# EUROPEAN PATENT APPLICATION

(11) **EP 3 488 962 A1**
(43) Date of publication of application: **29.05.2019**
(21) Application number: 17204195.6
(22) Date of filing: 28.11.2017
(51) Int. Cl.: B23K 35/26, B23K 35/36, C08K 3/08, C08L 83/00, H05K 3/32

(54) **SOLDER COMPOSITION AND METHOD OF SOLDERING**

(71) Applicant: Vestel Elektronik Sanayi ve Ticaret A.S., 45030 Manisa (TR)
(72) Inventor: ÖCAL, Ömür, 45030 Manisa (TR); SARIARSLAN, Muhammet Kürsat, 45030 Manisa (TR)
(74) Representative: Flint, Adam

(57) **Abstract**

A solder composition comprises a metal material for forming a joint between electrical components and a polymer for forming an electrically-resistive coating on the joint. The polymer has a melting point which is higher than a melting point of the metal material, such that when the metal material is melted the polymer separates from the metal material to form the electrically-resistive coating. The composition is useful for forming a solder joint and an electrically-resistive coating in a single step. Also provided are a use of the solder composition to form a joint between electrical components and an electrically resistive coating on the joint, and a method of soldering electrical components.

## Description

### Technical Field

The present invention generally relates to a solder composition, to a use of the solder composition, and to a method of soldering.

### Background

Solder is used in the manufacture of electrical devices to form conductive joints between electrical components. For example, components such as diodes, capacitors, integrated circuits, resistors and the like may be connected to a printed circuit board using solder. Soldered joints may be covered with a polymer layer, forming a resistive coating over the joints. This may help to prevent short-circuits and/or help to prevent corrosion of the joints. Applying a covering layer represents a separate process step to forming the solder joints.

US5062896A discloses a solder/polymer fluxless composite paste interconnection material having a low reflow temperature to form electrical contacts having good bonding strength and low contact resistance. When used in a reflow process, the composite paste forms a polymer-reinforced metal alloy interconnected network connection.

### Summary

According to a first aspect disclosed herein, there is provided a solder composition comprising: a metal material for forming a joint between electrical components; and a polymer for forming an electrically-resistive coating on the joint; wherein the polymer is a thermoplastic; and wherein the polymer has a melting point which is higher than a melting point of the metal material, such that when the metal material is melted, the polymer separates from the metal material to form the electrically-resistive coating.

The inclusion of the thermoplastic polymer in the solder composition allows an insulating layer to be formed in the same operation as the joint. This removes the need for a separate operation of applying a resistive coating when manufacturing an electronic device. This can help to improve the efficiency of the manufacturing process.

Optionally, the thermoplastic is a thermoplastic polyester. Thermoplastic polyesters may have appropriate physical and chemical properties.

The thermoplastic polyester may be a poly(alkylene terephthalate). Experiments conducted using poly(butylene terephthalate) demonstrated that this polymer readily separates from molten metal materials and forms an electrically-resistive coating having favourable properties, such as high resistivity. Polymers belonging to the same homologous series as poly(butylene terephthalate) generally have similar properties.

The poly(alkylene terephthalate) may be a poly(C2 to C6-alkylene terephthalate). Poly(ethylene terephthalate) is reported to have similar physical and chemical properties to poly(butylene terephthalate). Any poly(C2 to C6-alkylene terephthalate) will typically behave similarly to poly(butylene terephthalate). The poly(alkylene terephthalate) may be for example a poly(C3 to C5-alkylene terephthalate). Particularly preferably, the poly(alkylene terephthalate) is poly(butylene terephthalate). This material has been investigated and displays the desired behaviour.

Optionally, the metal material and the polymer are present at a ratio in the range 5:1 to 9:1 by weight, preferably 6:1 to 8:1, more preferably 6.5:1 to 7.5:1, and in one example about 7:1. Generally, increasing the proportion of polymer present in the composition improves the insulating properties of the electrically-resistive coating. It may however be desirable to maximise the proportion of metal material present in a solder composition. Ratios within these ranges may provide a good balance between the amounts of metal material and polymer.

Optionally, the metal material is an alloy comprising tin and lead. The alloy may comprise weight ratios of tin to lead in the range 5:95 to 70:30, optionally 45:55 to 65:35. Illustrative alloys have tin:lead ratios, by weight, of about 60:40, about 63:37, and about 50:50. The ratio of about 63:37 tin:lead is particularly preferred because this is a eutectic alloy having a low, well-defined melting point, *i.e.* 183°C at a pressure of 1 atm. Alloys comprising tin and lead may have advantageous properties, such as favourable melting points and a low tendency to form tin whiskers. Further elements such as silver, zinc and/or antimony may be included to adjust the properties of the alloy

Alternatively, the metal material may be a lead-free solder material. Regulations in many jurisdictions restrict the use of solders containing lead. A lead-free solder material may include tin, silver and copper. Such a material may include from 0.2 to 4 % silver and from 0.5 to 0.7 % copper by weight of the material, with the balance being tin. One illustrative lead-free solder comprises 0.3 % silver and 0.7 % copper by weight of the lead-free solder, the balance being tin.

Optionally, the solder composition further comprises flux. The flux may perform various functions, such as acting as a cleaning agent, flowing agent, and/or purifying agent. An illustrative flux comprises a mixture of hydrogenated rosin (CAS no. 65997-06-0) and denatured acid hydrogenation gum resin (CAS no. 144413-22-9).

The solder composition may be a cream solder composition comprising flux in an amount in the range 5 % to 30 % by weight of the cream solder composition, optionally 8 % to 15 % by weight. Cream solder compositions may be useful in paste-in-hole reflow processes. Industrial-scale manufacture of electronic devices often makes use of paste-in-hole reflow.

There is also provided a use of a solder composition as described above to form a joint between electrical components and an electrically resistive coating on the joint. Optionally, the solder composition is used in a reflow process.

According to a further aspect disclosed herein, there is provided a method of soldering electrical components, which method comprises:
arranging a first electrical component relative to a second electrical component in a position where a joint between the first and second electrical components is to be formed;
applying a solder composition to at least one of the first and second electrical components; and
heating the solder composition to form the joint between the first and second electrical components;
wherein the solder composition is a solder composition in accordance with the first aspect of the invention, and the solder composition is heated to a temperature which is above the melting point of the metal material but below the melting point of the polymer.

The method allows the formation of a joint and an electrically-resistive coating in a single process. A further separate operation of applying a resistive coating to the joints is not required. This may improve manufacturing efficiency.

The order of the arranging, applying and heating operations is not particularly limited and may be selected as appropriate. For example, in a reflow process, the solder composition may be applied before arranging the electrical components, and then subsequently heating. However, when soldering by hand, the electrical components are first arranged and then the applying and heating operations are carried out simultaneously. Suitably, the applying operation is performed before or simultaneously to the heating operation, preferably before.

Typically, one of the electrical components is a printed circuit board, and the other of the electrical components is any other component, for example a resistor, capacitor, diode, transistor, switch, integrated circuit, connector, or the like. The nature of the components to be joined is not particularly limited.

Preferably, the method is a paste-in-hole reflow method. In an illustrative pin-in-hole reflow process, solder paste is applied to holes in a printed circuit board. Connector pins of the components are inserted into the holes the resulting assembly is then heated to re-flow the solder and form electrical connections between the connector pins and the printed circuit board.

### Brief Description of the Drawings

To assist understanding of the present disclosure, reference is made by way of example to the accompanying drawings in which:
Figure 1 shows schematically a stage of a paste-in-hole soldering method, in which a printed circuit board has been provided with a cream solder before arranging components on the printed circuit board; and
Figure 2 shows schematically a component which has been attached to a printed circuit board using a solder composition according to the invention.

### Detailed Description

Unless otherwise stated, all percentages recited in the present specification are percentages by weight of the solder composition. Likewise, unless otherwise stated all ratios are by weight.

As used herein, the verb "to comprise" is used as shorthand for "to include or to consist of". In other words, although the verb "to comprise" is an 'open' term, the replacement of this term with the 'closed' term "to consist of" is explicitly contemplated.

As used herein, the word "about" when used in connection with a numeral value contemplates a variance of up to ±10 %, optionally a variance of up to ±1 %.

A thermoplastic is a polymer material having a melting point which is lower than a thermal decomposition temperature of the material, *i.e.* which will melt before it decomposes.

An electrically-resistive coating is a layer which acts as an electrical insulator.

Provided herein is a solder composition comprising a metal material for forming a joint between electrical components, and a polymer for forming an electrically-restive coating on the joint. The polymer is a thermoplastic. The polymer has a melting point which is higher than a melting point of the metal material, such that when the metal material is melted the polymer separates from the metal material to form the electrically-resistive coating.

It has been found that the thermoplastic polymer may separate from the metal material when the solder composition is heated to a temperature which is above the melting point of the metal material and below the melting point of the polymer. The metal material used in the present invention has a higher density than the thermoplastic polymer, which is believed to remain in the solid state. The thermoplastic polymer therefore rises to the surface of the molten mixture. This behaviour allows for the formation of a solder joint having an electrically-resistive coating in a single process step, without requiring a separate coating operation.

Suitable combinations of metal materials and thermoplastic polymers may be identified by straightforward experiments. One illustrative testing method is as follows. A mixture comprising the metal material and the thermoplastic polymer of interest is prepared. The mixture may further include a flux. The metal material and the thermoplastic polymer may be suspended in the flux. The mixture is heated to a temperature which is above the melting point of the metal material and below the melting point of the polymer. The mixture is then allowed to cool. The formation of a polymer coating can then be detected by simple visual inspection. Those polymers which form composites rather than undergoing phase separation will fail to form a visible polymer coating.

Suitable thermoplastic polymers may be free of functional groups capable of chelating metal centres, such as carboxylic acid groups. The thermoplastic polymer may be free of anionic groups. Generally, the thermoplastic copolymer is not a siloxane. Generally, the thermoplastic polymer is not a polyimide. In particular, the thermoplastic polymer is generally not a poly(imide siloxane), because some poly(imide siloxane) polymers are reported to form composites.

The thermoplastic polymer may be a V-0 class thermoplastic polymer, according to Standard UL-94 (Standard for Safety of Flammability of Plastic Materials for Parts in Devices and Appliances Testing), Edition 6, published 28 March 2013, Underwriters Laboratories, USA. It is believed that any V-0 class thermoplastic polymer having electrically-insulating properties will be useful in the practice of the invention.

A class of thermoplastic polymers which includes useful polymers is the thermoplastic polyesters. In particular, thermoplastic polyesters based on terephthalate monomers may be suitable. The thermoplastic polyester may be a homopolymer or copolymer of terephthalic acid (benzene 1,4-dicarboxylic acid). Illustrative thermoplastic polyesters based on terephthalate monomers include the poly(alkylene terephthalate) polymers.

From experiments conducted using poly(butylene terephthalate), it is believed that poly(C2 to C6-alkylene terephthalate) polymers will form an electrically-resistive coating. The poly(C2 to C6-alkylene terephthalate) polymers are poly(ethylene terephthalate), poly(propylene terephthalate) poly(butylene terephthalate), poly(pentylene terephthalate) and poly(hexylene terephthalate). Of these, the poly(C3 to C5-alkylene terephthalate) polymers are preferred. The most preferred thermoplastic polyester is poly(butylene terephthalate), the structure of which is shown in Formula 1, below:

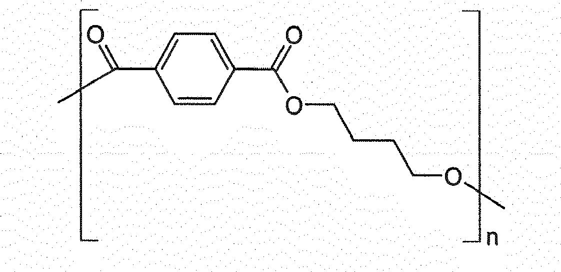

The ratio of metal material to polymer by weight is not particularly limited, and may be varied as desired to adjust, for example, the thickness of the electrically-resistive coating layer. It has been found that the insulating properties of the electrically-resistive layer improve as the proportion of polymer present increases. Typically, the metal material and the polymer are present at a ratio in the range 5:1 to 9:1 by weight, preferably 6:1 to 8:1, more preferably 6.5:1 to 7.5:1, and in a specific example about 7:1. Weight ratios in these ranges are believed to provide a good balance between maximising the proportion of metal material present in the solder composition and providing a coating layer which is neither too thick nor too thin.

The solder composition includes a metal material for forming a joint between electrical components. Suitable metal materials are those known in the art as solders, particularly soft solders (*i.e.* solders having a melting point in the range 90°C to 450°C). The metal material is usually an alloy, however, some pure metals (for example, tin) are suitable. It is believed that any of the metal alloys known in the art as solders may be used in the practice of the invention. The metal material may have a melting point in the range 150°C to 250°C, optionally 170°C to 230°C, further optionally 180°C to 220°C. The melting point of the polymer may be at least about 5°C above the melting point of the metal material, optionally at least about 10 °C above the melting point of the metal material. For example, the melting point of the polymer may be from 5°C to 50°C above the melting point of the metal material.

One illustrative example of a metal material is an alloy comprising tin and lead. The weight ratio of tin to lead present in the alloy may be in the range 5:95 to 70:30, optionally 45:55 to 65:35. A eutectic alloy having a tin to lead ratio of 63:37 by weight may be used. A tin:lead alloy may further comprise one or more of silver, zinc and antimony.

For some applications, it may be preferable to use a metal material which is a lead-free solder material. Lead-free solders are known in the art. One example of a lead-free solder material is an alloy comprising tin, silver and copper. Such a material may include from 0.2 to 4 %, optionally 3 to 4 %, silver and from 0.5 to 0.7 % copper by weight of the material, with the balance being tin. An illustrative lead-free solder comprises 0.3 % silver and 0.7 % copper by weight of the lead-free solder, with the balance being tin.

The solder composition optionally further comprises flux. Fluxes useful in solder compositions are well-known in the art. The flux may be, for example, a mixture including hydrogenated rosin (CAS no. 65997-06-0) and denatured acid hydrogenation gum resin (CAS no. 144413-22-9).

When the solder composition includes a flux, the composition may be in the form of a cream solder composition. Cream solder compositions may also be referred to in the art as solder pastes. A cream solder composition or solder paste of the invention may comprise particles of metal material and polymer suspended in the flux. The amount of flux present in the cream solder composition or solder paste may be in the range 5 % to 30 % by weight of the composition, optionally 8 % to 15 % by weight. Solder pastes and solder creams are useful in reflow processes, such as paste-in-hole reflow as will be explained in further detail below.

A second aspect of the present invention provides the use of the solder composition of the invention to form a joint between electrical components and an electrically resistive coating on the joint. The joint may be, in particular, a joint between a pin of a component and a pad of a printed circuit board. The use is typically in a reflow process.

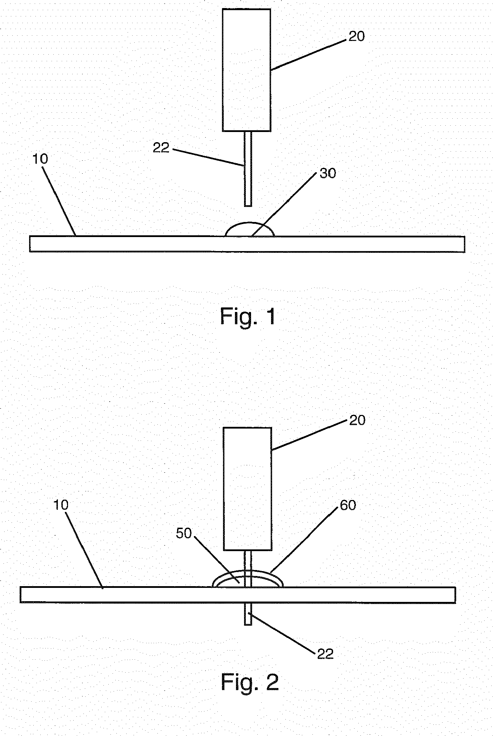

An illustrative embodiment of a method of soldering electrical components according to the invention will now be explained with reference to Figures 1 and 2. The illustrated method is a paste-in-hole reflow method.

Referring to Figure 1, a printed circuit board 10 includes a hole (not pictured) for receiving pin 22 of component 20. A volume of solder paste 30 is introduced into the hole. The solder paste 30 is a solder composition according to the present invention.

Pin 22 is inserted into the hole of printed circuit board 10. The resulting assembly is then heated to a temperature above the melting point of the metal material but below the melting point of the polymer. The heating may be carried out using for example a reflow oven or infrared lamp. The heating may include a ramp-up phase, in which the temperature is raised to a soak temperature below the melting point of the metal material and polymer; a soak phase, where the temperature is held at the soak temperature; and a further ramp-up phase, in which the temperature is raised from the soak temperature to the temperature above the melting points. Heat may alternatively be applied to individual joints rather than the assembly as a whole, using for example a hot air pencil.

The heat melts the metal material, but not the polymer. The polymer separates from the molten metal material. The polymer has a lower density than the molten metal material, and thus rises to the surface.

The assembly is then cooled, forming a conductive joint 50 between printed circuit board 10 and pin 22 of component 20, as well as an insulating layer 60 covering an outer surface of joint 50.

Although the method has been illustrated with reference to a reflow process, the solder composition may also be used in a manual process using a soldering iron. In such a process, a pin of a component is inserted into a hole in a printed circuit board. The pin and the corresponding pad are heated using a soldering iron. The solder composition e.g. in the form of a wire, is applied to the heated area and the metal material melts, thereby forming the joint and electrically-resistive coating.

### Example

A solder cream comprising a tin-lead alloy as the metal material and poly(butylene terephthalate) as the polymer suspended in a conventional flux is prepared. The weight ratio of the tin-lead alloy to poly(butylene terephthalate) is about 7:1.

The solder cream is applied to holes in a printed circuit board. Pins of electrical components are inserted into the holes. The resulting assembly is then heated to a temperature which is above the melting point of the metal material but below the melting point of the polymer, before being cooled. The solder cream is observed to form conductive solder joints between the pins and the printed circuit board and an insulating polymer coating on the joints.

The examples described herein are to be understood as illustrative examples of embodiments of the invention. Further embodiments and examples are envisaged. Any feature described in relation to any one example or embodiment may be used alone or in combination with other features. In addition, any feature described in relation to any one example or embodiment may also be used in combination with one or more features of any other of the examples or embodiments, or any combination of any other of the examples or embodiments. Furthermore, equivalents and modifications not described herein may also be employed within the scope of the invention, which is defined in the claims.

## Claims

1. A solder composition, comprising:
a metal material for forming a joint between electrical components; and
a polymer for forming an electrically-resistive coating on the joint;
wherein the polymer is a thermoplastic; and
wherein the polymer has a melting point which is higher than a melting point of the metal material, such that when the metal material is melted the polymer separates from the metal material to form the electrically-resistive coating.

2. The solder composition according to claim 1, wherein the thermoplastic is a thermoplastic polyester.

3. The solder composition according to claim 2, wherein the thermoplastic polyester is a poly(alkylene terephthalate).

4. The solder composition according to claim 3, wherein the poly(alkylene terephthalate) is a poly(C2 to C6-alkylene terephthalate).

5. The solder composition according to claim 4, wherein the poly(alkylene terephthalate) is a poly(C3 to C5-alkylene terephthalate).

6. The solder composition according to claim 5, wherein the poly(alkylene terephthalate) is poly(butylene terephthalate).

7. The solder composition according to any preceding claim, wherein the metal material and the polymer are present at a ratio in the range 5:1 to 9:1 by weight.

8. The solder composition according to any preceding claim, wherein the metal material is an alloy comprising tin and lead.

9. The solder composition according to any of claims 1 to 7, wherein the metal material is a lead-free solder material.

10. The solder composition according to any preceding claim, further comprising flux.

11. The solder composition according to claim 10, which is a cream solder composition comprising flux in an amount in the range 5 % to 30 % by weight of the cream solder composition.

12. Use of the solder composition according to any preceding claim to form a joint between electrical components and an electrically-resistive coating on the joint.

13. A method of soldering electrical components, which method comprises:
arranging a first electrical component relative to a second electrical component in a position where a joint between the first and second electrical components is to be formed;
applying a solder composition to at least one of the first and second electrical components; and
heating the solder composition to form the joint between the first and second electrical components;
wherein the solder composition is as defined in any of claims 1 to 12, and the solder composition is heated to a temperature which is above the melting point of the metal material but below the melting point of the polymer.

14. The method according to claim 13, which is a paste-in-hole reflow method.
